Europäisches Patentamt

European Patent Office

Office européen des brevets

(11) Veröffentlichungsnummer: **0 243 669 B1**

## EUROPÄISCHE PATENTSCHRIFT

(45) Veröffentlichungstag der Patentschrift: **10.04.91**

(51) Int. Cl.5: **G01R 33/38**, G01R 33/42

(21) Anmeldenummer: **87104226.3**

(22) Anmeldetag: **23.03.87**

(54) **Rahmenstruktur für ein Magnetsystem einer Anlage zur Kernspin-Tomographie.**

(30) Priorität: **21.04.86 DE 3613405**

(43) Veröffentlichungstag der Anmeldung:
**04.11.87 Patentblatt 87/45**

(45) Bekanntmachung des Hinweises auf die
Patenterteilung:
**10.04.91 Patentblatt 91/15**

(84) Benannte Vertragsstaaten:
**DE FR GB IT**

(56) Entgegenhaltungen:
**EP-A- 0 067 933**
**EP-A- 0 102 486**
**EP-A- 0 111 219**
**EP-A- 0 139 308**
**EP-A- 0 141 149**

(73) Patentinhaber: **Siemens Aktiengesellschaft**
**Wittelsbacherplatz 2**
**W-8000 München 2(DE)**

(72) Erfinder: **Forster, Helmut**
**Forchheimer Strasse 27**
**W-8524 Neunkirchen a. Brand(DE)**
Erfinder: **Siebold, Horst, Dr. Dipl.-Phys.**
**Reuthlehenstrasse 63**
**W-8520 Erlangen(DE)**

## Beschreibung

Die Erfindung bezieht sich auf eine Rahmenstruktur mit Vorrichtungen zur Halterung und/oder räumlichen Justierung zumindest einzelner längs einer gemeinsamen Achse hintereinandergereihter, ringförmiger Magnetspulen eines Magnetsystems, das zur Erzeugung eines homogenen magnetischen Grundfeldes einer Anlage der Kernspin-Tomographie dient, wobei die Struktur mehrere achsenparallel verlaufende Rahmenteile aufweist. Eine entsprechende Rahmenstruktur geht aus der EP 0 102 486 A1 hervor.

Auf dem Gebiet der medizinischen Diagnostik sind bildgebende Verfahren entwickelt worden, in denen rechnerisch oder meßtechnisch integrale Resonanzsignale von Kernen eines bestimmten Elementes eines zu untersuchenden, insbesondere menschlichen Körpers oder Körperteiles analysiert werden. Aus der so zu gewinnenden räumlichen Spindichte- und/oder Relaxationszeitverteilung läßt sich dann ein Bild ähnlich einem Röntgentomographiebild konstruieren. Entsprechende Techniken sind unter der Bezeichnung "Kernspin-Tomographie" (Nuclear Magnetic Resonance Tomography) oder "Zeugmatographie" bekannt.

Für die Kernspin-Tomographie ist ein von einem sogenannten Grundfeldmagneten erzeugtes starkes Magnetfeld Voraussetzung, das in einem Abbildungs- bzw. Untersuchungsbereich vorbestimmter Ausdehnung möglichst homogen sein soll und in das der zu untersuchende Körper längs einer Achse, die im allgemeinen mit der Orientierungsachse des magnetischen Grundfeldes übereinstimmt, eingebracht wird. Dieses Grundfeld wird von stationären und/oder gepulsten, sogenannten Gradientenfeldern überlagert. Zur Anregung der einzelnen Atomkerne in dem Körper zu einer Präzessionsbewegung ist außerdem eine besondere Antenneneinrichtung erforderlich, mit der kurzzeitig ein hochfrequentes magnetisches Wechselfeld angeregt werden kann. Vielfach werden mit dieser Einrichtung auch die so hervorgerufenen HF-Signale empfangen, falls man hierfür keine besonderen Meßschleifen vorsehen möchte.

Der Grundfeldmagnet kann als ein System von z.B. sechs in Richtung der Feldorientierung des magnetischen Grundfeldes hintereinandergereihten Magnetspulen ausgebildet sein. Um nun die angestrebte hohe Homogenität des Magnetfeldes erreichen zu können, müssen dabei zumindest einzelne dieser Spulen geometrisch fein-justierbar sein. Hierzu ist besonders die aus der eingangs genannten EP-A bekannte Justierungs- und Halterungsvorrichtung geeignet. Diese bekannte Vorrichtung weist eine ortsfeste Rahmenstruktur aus magnetisch nicht-leitendem Material auf, die zwei untere Tragschienen zur Aufnahme des Gewichtes der Magnetspulen und eine obere Halteschiene zur Halterung der Magnetspulen umfaßt. Diese achsenparallel verlaufenden Rahmenteile sind untereinander über eine oder mehrere Magnetspulen zu einer starren Struktur mechanisch fest verbunden. Zur Justierung der übrigen Magnetspulen sind an der so ausgebildeten Rahmenstruktur besondere Stelleinrichtungen angebracht, mit deren Hilfe die einzelnen Spulen aus ihrer senkrechten Lage bezüglich der Orientierungsachse des magnetischen Grundfeldes leicht zu kippen sind.

Für derartige Magnetsysteme besteht vielfach der Wunsch nach einer magnetischen Abschirmung bzw. einem magnetischen Rückschluß. Ein ferromagnetischer Rückschlußkörper in Form eines Hohlzylinders um ein Kernspintomographie-Spulensystem ist z.B. aus der EP 0 067 933 B1 bekannt. Eine vorteilhafte Auflösung dieses hohlzylindrischen Rückschlußkörpers in einzelne balkenartige Abschirmelemente ist darüber hinaus der EP 0 141 149 A1 zu entnehmen. Wollte man nun eine solche magnetische Abschirmung um das innerhalb einer Rahmenstruktur der eingangs genannten Art gehaltene Magnetsystem vorsehen, so wäre nicht nur der Material-und Platzbedarf verhältnismäßig hoch; sondern es wäre auch der Zugang zu den einzelnen Magnetspulen innerhalb der Rahmenstruktur zum Zwecke einer Feinjustierung aufgrund der magnetischen Abschirmung erschwert.

Aufgabe der vorliegenden Erfindung ist es deshalb, die bekannte Rahmenstruktur dahingehend zu gestalten, daß eine verhältnismäßig einfache magnetische Abschirmwirkung ermöglicht ist, ohne daß dabei die genannten Schwierigkeiten auftreten.

Diese Aufgabe wird erfindungsgemäß mit den im Kennzeichen des Hauptanspruchs angegebenen Maßnahmen gelöst.

In die erfindungsgemäße Rahmenstruktur sind also die balken-, stangen- oder plattenförmigen Abschirmelemente integriert, wobei diese Elemente die achsenparallel verlaufenden Rahmenteile der Struktur darstellen. Auf diese Weise ist vorteilhaft ein kompakter Aufbau der Rahmenstruktur mit hoher Stabilität zu gewährleisten, wobei zugleich die Funktion der magnetischen Abschirmung mit ausgeübt wird.

Vorteilhafte Ausgestaltungen der erfindungsgemäßen Rahmenstruktur gehen aus den Unteransprüchen hervor.

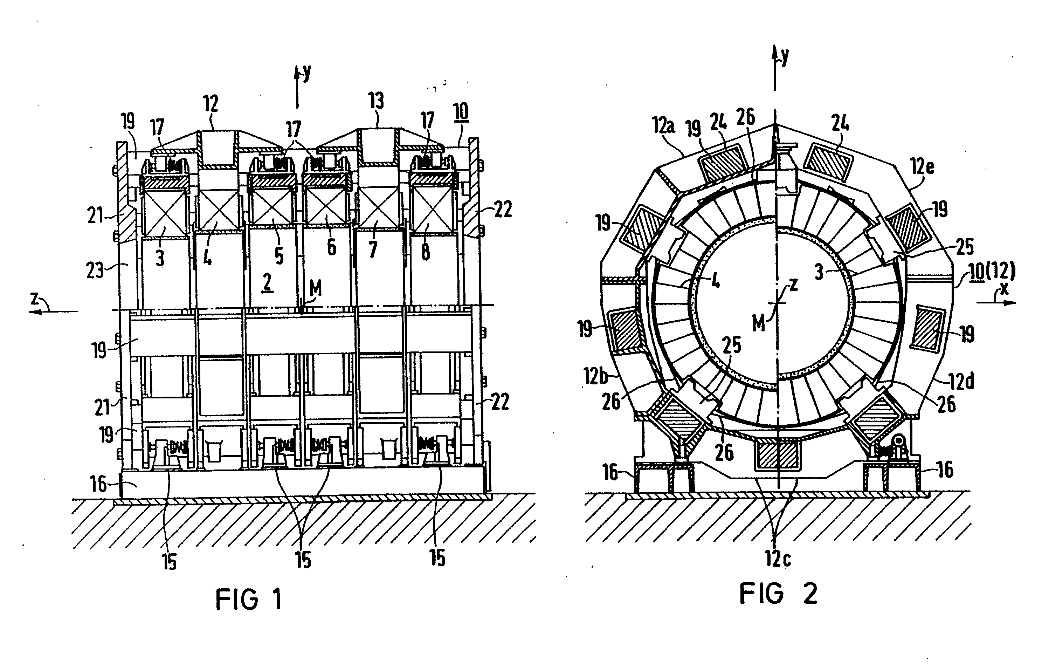

Zur weiteren Erläuterung der Erfindung wird auf die Zeichnung Bezug genommen, in deren Figuren 1 und 2 die erfindungsgemäße Rahmenstruktur in verschiedenen Ansichten schematisch veranschaulicht ist. In diesen Figuren sind übereinstimmende Teile mit den gleichen Bezugszeichen versehen.

Bei dem in Figur 1 als Längsschnitt (obere Hälfte) bzw. als Seitenansicht (untere Hälfte) dargestellten Magnetsystem wird von bekannten Ausführungsformen einer bildgebenden Einrichtung der Kernspinresonanz-Technik ausgegangen. Das allgemein mit 2 bezeichnete Magnetsystem soll dabei bezüglich der horizontalen z-Achse eines rechtwinkligen x-y-z-Koordinatensystems konzentrisch angeordnet sein und von sechs normal- oder supraleitenden Einzelspulen 3 bis 8 gebildet werden. Mit diesen Spulen ist ein hinreichend homogenes magnetisches Grundfeld in einem zentralen Abbildungsbereich zu erzeugen, in dessen Mittelpunkt M sich der Koordinatenursprung des Koordinatensystems befinden soll. Das Magnetsystem 2 erlaubt einen axialen Zugang zu diesem homogenen Abbildungsbereich; d.h., ein zu untersuchender, beispielsweise menschlicher Körper ist längs der z-Achse in diesen Feldbereich einzubringen.

Die sechs längs der z-Achse hintereinandergereihten, ringförmigen Magnetspulen 3 bis 8 des Magnetsystems 2 sind vorteilhaft innerhalb einer erfindungsgemäß ausgestalteten Rahmenstruktur 10 justierbar gehalten. Dabei sind zwei der Magnetspulen, vorzugsweise die den beiden stirnseitigen Magnetspulen 3 und 8 jeweils benachbarten Spulen 4 und 7, starr mit dieser Rahmenstruktur 10 verbunden. Hierzu dienen ringförmige Spulenaufnahmeelemente 12 und 13 aus nicht-ferromagnetischem Material wie z.B. aus einem Guß einer Aluminiumlegierung. Diese Elemente liegen jeweils in einer zur z-Achse senkrechten, d.h. radialen Ebene. Die übrigen Magnetspulen 3, 5, 6 und 8 stützen sich innerhalb dieser Rahmenstruktur 10 über besondere Abstützungseinrichtungen 15 an mindestens einem Bodenteil 16 ab. Außerdem sind diese Magnetspulen mittels besonderer mechanischer Stelleinrichtungen 17, die ebenfalls an der Rahmenstruktur 10 angebracht sind, gegenseitig auszurichten. Einzelheiten dieser Abstützungseinrichtungen 15 und dieser Stelleinrichtungen 17 sind z.B. der genannten EP-A-0 102 486 A1 zu entnehmen.

Die achsenparallel verlaufenden Teile der Rahmenstruktur 10 sind erfindungsgemäß von mehreren balken-, stangen-oder plattenförmigen Abschirmelementen 19 aus ferromagnetischem Material gebildet. Die Anordnung dieser Elemente 19 geht aus Figur 2 näher hervor. Wie ferner aus Figur 1 ersichtlich ist, sind an den Stirnseiten der Rahmenstruktur 10 noch plattenförmige Abschirmteile 21 und 22 aus ferromagnetischem Material angebracht, die jeweils eine zentrale Öffnung 23 vorbestimmter Größe aufweisen. Diese auch als Poleisen oder Endplatten bezeichneten Abschirmteile sind in bekannter Weise für eine hinreichende Abschirmwirkung erforderlich. Sie sind mit den Abschirmelementen 19 starr verbunden, beispielsweise verschraubt. Auf diese Weise wird eine hinreichend große mechanische Stabilität der aus den Teilen 12, 13, 19, 21 und 22 bestehenden Rahmenstruktur 10 gewährleistet.

Der Aufbau der erfindungsgemäßen Rahmenstruktur 10 ist deutlicher aus den Querschnitten der Figur 2 ersichtlich. Dabei sind je ein Schnitt teils in eine Ebene durch die Magnetspule 4 (linke Hälfte von Figur 2), teils in eine Ebene durch die Magnetspule 3 (rechte Hälfte der Figur 2) gelegt. Von den beiden gleich aufgebauten, ringähnlichen Spulenaufnahmeelementen 12 und 13 der Rahmenstruktur 10 ist in der Figur nur das Element 12 zu sehen, das aus mehreren, beispielsweise fünf segmentartigen Einzelstücken aus dem nicht-magnetischen Material zusammensetzbar ist. Diese fünf z.B. miteinander verschraubbaren Einzelstücke sind in der Figur mit 12a bis 12e bezeichnet. Sie weisen außerdem mehrere, beispielsweise neun axiale Öffnungen oder Durchführungen 24 gleicher Abmessungen auf, in welche die balken- oder stangenartigen Abschirmelemente 19 aus ferromagnetischem Material mit entsprechenden Querabmessungen einzusetzen sind. Die Lage der Öffnungen 24 bzw. der Abschirmelemente 19 ist dabei so gewählt, daß diese auf einer gemeinsamen gedachten (imaginären) Zylindermantelfläche um die z-Achse liegen und untereinander, in Umfangsrichtung gesehen regelmäßig verteilt angeordnet sind. Dabei ist die Gestaltung und Funktionsweise dieser Abschirmelemente 19, welche die sich in axialer Richtung erstreckenden Teile der Rahmenstruktur 10 darstellen, an sich bekannt (vgl. z.B. die genannte EP-A-0 141 149 ).

Aus dem Querschnitt der Figur 2 gehen darüber hinaus noch an den ringartigen Befestigungsteilen 12 und 13 angebrachte Befestigungsklauen 25 hervor, die von außen her in entsprechende Aussparungen in den Magnetspulenkörper eingreifen und zusammen mit Spannbändern 26 für eine unverrückbare Halterung der einzelnen Magnetspulen innerhalb der Rahmenstruktur 10 sorgen.

Gemäß der Erfindung ist also in eine käfigartige Rahmenstruktur um ein System von mehreren ringförmigen Magnetspulen ein ferromagnetischer Rückschluß mit integriert. Hierbei können die gegenseitig beabstandeten ferromagnetischen Abschirmelemente, welche die axialen Teile dieser Struktur darstellen und untereinander mittels der beiden stirnseitigen ferromagnetischen Endplatten verbunden sind, auch andere als die in den Figuren dargestellten Querschnitte aufweisen. Derartige Rahmenstrukturen sind einerseits verhältnismäßig einfach vor Ort zu montieren. Andererseits gewährleisten sie eine sichere Halterung der einzelnen ringförmigen Magnetspulen bei gleichzeitiger Justierungsmöglichkeit.

## Ansprüche

1. Rahmenstruktur mit Vorrichtungen zur Halterung und/oder räumlichen Justierung zumindest einzelner längs einer gemeinsamen Achse hintereinandergereihter, ringförmiger Magnetspulen (3-8) eines Magnetsystems, das zur Erzeugung eines homogenen magnetischen Grundfeldes einer Anlage der Kernspin-Tomographie dient, wobei die Struktur mehrere achsenparallel verlaufende Rahmenteile aufweist, mit denen einzelne der Magnetspulen starr verbunden sind, **dadurch gekennzeichnet,**
   - daß die Rahmenteile balken-, stangen- oder plattenförmige magnetische Abschirmelemente (19, 28) sind, die auf einer gedachten, das Magnetsystem (2) umschließenden Zylindermantelfläche in Umfangsrichtung regelmäßig verteilt und gegenseitig beabstandet angeordnet sind,
   - daß an den Stirnseiten dieser käfigartigen Rahmenstruktur (10, 25) je ein plattenförmiges magnetisches Abschirmteil (21,22) mit zentraler Öffnung (23) vorbestimmten Radius' vorgesehen ist, und
   - daß für die starre Verbindung der einzelnen Magnetspulen (4, 7) mit den achsenparallelen, als Rahmenteile dienenden Abschirmelementen (19) ringähnliche Spulenaufnahmeelemente (12, 13) aus nicht-ferromagnetischem Material vorgesehen sind.

2. Rahmenstruktur nach Anspruch 1, **dadurch gekennzeichnet,** daß die ringähnlichen Spulenaufnahmeelemente (12, 13) aus mehreren segmentartigen Einzelstücken (l2a bis l2e) zusammensetzbar sind.

3. Rahmenstruktur nach Anspruch 1 oder 2, **dadurch gekennzeichnet,** daß die ringähnlichen Spulenaufnahmeelemente (12, 13) mit Durchführungen (24) versehen sind, durch welche die achsenparallelen Abschirmelemente (19) mit entsprechendem Querschnitt hindurchsteckbar sind.

## Claims

1. Frame structure with devices for supporting and/or spatially adjusting at least individual ring-shaped magnetic coils (3 - 8) of a magnet system, the coils being lined up one behind the other along a common axis, which magnet system is used to generate a homogenous magnetic base field for a nuclear spin tomography installation, wherein the structure has several frame parts extending parallel to the axis, to which individual magnetic coils are rigidly connected, characterised in that
   - the frame parts are beam-, rod- or plate-shaped magnetic shielding elements (19, 28) which are arranged to be uniformly distributed and spaced apart from each other in the circumferential direction on an imaginary cylinder surface surrounding the magnet system (2),
   - a plate-shaped magnetic shielding part (21, 22) with a central opening (23) of predetermined radius is provided on each of the end faces of this cage-like frame structure (10, 25), and
   - ring-like coil receiving elements (12, 13) of nonferromagnetic material are provided for the rigid connection of the individual magnetic coils (4, 7) to the shielding elements (19) extending parallel to the axis and used as frame parts.

2. Frame structure according to claim 1, characterised in that the ring-like coil receiving elements (12, 13) can be assembled from several segment-like individual pieces (12a to 12e).

3. Frame structure according to claim 1 or 2, characterised in that the ring-like coil receiving elements (12, 13) are provided with through passages (24) through which the shielding elements (19), extending parallel to the axis and with a corresponding cross-section, can be inserted.

## Revendications

1. Structure en forme de cadre comportant des dispositifs pour maintenir et/ou ajuster dans l'espace au moins des bobines magnétiques de forme annulaire (individuelles (3-8),) disposées les unes derrière les autres le long d'un axe commun, d'un système magnétique, qui sert à produire un champ magnétique homogène de base d'une installation de tomographie à résonance magnétique nucléaire, la structure possédant plusieurs éléments de cadre, qui s'étendent parallèlement à l'axe, et auxquels sont reliées rigidement certaines des bobines magnétiques, caractérisée par le fait
   - que les éléments de cadre sont des éléments magnétiques de blindage (19,28) en forme de poutres, de barres ou de plaques, formant écran magnétique et qui sont répartis de façon uniforme dans la direction circonférentielle sur une surface enveloppe cylindrique imaginaire entourant le système magnétique (2 ), et qui sont distants les uns des autres,
- que sur chacune des faces frontales de cette structure en forme de cadre (10,25 ), agencée à la manière d'une cage, il est prévu respectivement un élément formant écran magnétique de blindage (21,22), en forme de plaque, possédant une ouverture centrale (23) ayant d'un rayon prédéterminé, et
- que pour la liaison rigide des différentes bobines magnétiques (4,7) avec les éléments formant écran (19) qui sont parallèles à l'axe et qui sont utilisés comme éléments de cadre, il est prévu des éléments (12,13) servant à recevoir des bobines et réalisés, avec une forme similaire à celle d'un anneau, en un matériau non ferromagnétique.

2. Structure en forme de cadre suivant la revendication 1, caractérisée par le fait que les éléments (12,13) servant à recevoir des bobines, et qui ont une forme similaire à celle d'un anneau, peuvent être formés par la réunion de plusieurs éléments individuels en forme de segments (l2a à 12e).

3. Structure en forme de cadre suivant la revendication 1 ou 2, caractérisée par le fait que les éléments (12,13) servant à recevoir des bobines, et qui ont une forme similaire à celle d'un anneau, comportent des passages (24), dans lesquels peuvent être introduit les éléments formant écran (19) qui sont parallèles à l'axe et qui possèdent une section transversale correspondante.

FIG 2

FIG 1